# EUROPÄISCHE PATENTSCHRIFT

(11) **EP 3 321 649 B1**
(45) Veröffentlichungstag und Bekanntmachung des Hinweises auf die Patenterteilung: **14.12.2022**
(21) Anmeldenummer: 17194316.0
(22) Anmeldetag: 02.10.2017
(51) Int. Cl.: G01J 3/02, G01J 3/10, G01J 3/26, H01L 33/50

(54) **BELEUCHTUNGSEINHEIT FÜR EIN MIKROSPEKTROMETER, MIKROSPEKTROMETER UND MOBILES ENDGERÄT**
LIGHTING UNIT FOR A MICRO-SPECTROMETER, MICRO-SPECTROMETER AND MOBILE TERMINAL
UNITÉ D'ÉCLAIRAGE POUR UN MICROSPECTROMÈTRE, MICROSPECTROMÈTRE ET TERMINAL

(30) Priorität: 10.11.2016 DE 102016222047
(43) Veröffentlichungstag der Anmeldung: 16.05.2018
(73) Patentinhaber: Robert Bosch GmbH, 70442 Stuttgart (DE)
(72) Erfinder: Baumgart, Eugen, 70376 Stuttgart (DE)

(56) Entgegenhaltungen:
- EP-A2- 1 857 790
- WO-A2-2016/125164
- DE-A1-102015 106 635
- US-A1- 2009 295 910
- US-A1- 2013 229 646

## Beschreibung

### Stand der Technik

Die Erfindung geht aus von einer Vorrichtung oder einem Verfahren nach Gattung der unabhängigen Ansprüche.

Spektrometer basieren auf der Detektion und spektralen Aufspaltung von Licht, das von einem untersuchten Objekt emittiert oder gestreut wird. Um beispielsweise die Qualität oder den Zucker- oder Fettgehalt von Nahrungsmitteln zu analysieren, kann ein solches Gerät über eine eigene Lichtquelle verfügen, dessen Spektrum nach Interaktion mit der Probe Informationen über das untersuchte Objekt trägt.

Die DE 10 2015 106 635 A1 offenbart eine optoelektronische Anordnung mit einem optoelektronischen Halbleiterchip, einem wellenlängenkonvertierenden Element und einem Detektorbauteil. Der optoelektronische Halbleiterchip ist ausgebildet, Licht mit einer ersten Peak-Wellenlänge zu emittieren und das wellenlängenkonvertierende Element ist ausgebildet, von dem optoelektronischen Halbleiterchip emittiertes Licht in Licht mit einer zweiten Peak-Wellenlänge zu konvertieren. Die EP 1 857 790 A2 offenbart eine Beleuchtungsquelle mit einem photolumineszenten Material. Die EP 1 857 790 A2 offenbart ein Spektrometersystem und die EP 1 857 790 A2 einen Komponentenanalysator.

### Offenbarung der Erfindung

Vor diesem Hintergrund werden mit dem hier vorgestellten Ansatz eine Beleuchtungseinheit für ein Mikrospektrometer, ein Mikrospektrometer, ein mobiles Endgerät sowie ein Verfahren zum Beleuchten einer Probe mittels einer Beleuchtungseinheit gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Es wird eine Beleuchtungseinheit für ein Mikrospektrometer vorgestellt, wobei die Beleuchtungseinheit die Merkmale aus Anspruch 1 aufweist.

Unter einem Mikrospektrometer kann ein miniaturisiertes Modul zum Ermitteln einer spektralen Zusammensetzung eines von einer Probe reflektierten Lichtstrahls verstanden werden. Beispielsweise kann das Mikrospektrometer eine Breite und/oder Länge von kleiner 10 mm und eine Höhe von kleiner 5 mm aufweisen. Unter einer Laser-Anregungslichtquelle kann beispielsweise eine Laserquelle, etwa eine Laserdiode, zum Aussenden eines Laserstrahls als den Anregungsstrahl verstanden werden. Bei dem Anregungsstrahl kann es sich um kurzweilige elektromagnetische Strahlung wie etwa Ultraviolettstrahlung oder blaues Licht handeln. Die Laser-Anregungslichtquelle kann insbesondere in einem Verfahren der Halbleitertechnik gefertigt sein. Unter einem Fluoreszenzelement kann ein miniaturisiertes Bauteil mit einem fluoreszierenden Stoff wie beispielsweise Phosphor verstanden werden. Der fluoreszierende Stoff kann durch den Anregungsstrahl zum Aussenden des Beleuchtungsstrahls angeregt werden. Beispielsweise kann das Fluoreszenzelement ausgebildet sein, um unter Verwendung des Anregungsstrahls einen polychromatischen Lichtstrahl, d. h. weißes Licht, als den Beleuchtungsstrahl auszusenden. Unter einem Anregungs- oder Beleuchtungsstrahl kann entweder ein einzelner, geradliniger Strahl zur vereinfachten Darstellung eines Strahlenganges oder ein divergierendes, paralleles oder konvergierendes Strahlenbündel verstanden werden.

Der hier vorgestellte Ansatz beruht auf der Erkenntnis, dass auf Basis eines laserangeregten Fluoreszenzelements, etwa eines Phosphors, eine miniaturisierte Weißlichtquelle mit geringer Etendue für ein Mikrospektrometer realisiert werden kann.

Dies hat den Vorteil, dass die Größe des Emissionspunktes der Lichtquelle im Vergleich zu Weißlicht-LEDs signifikant verringert werden kann, sodass näherungsweise eine Punktquelle mit hoher Intensität realisiert werden kann. Dadurch kann Licht mithilfe geeigneter Mikrolinsen auch bei kleinem Bauraum kollimiert oder auf einen kleinen Bereich abgebildet, insbesondere fokussiert werden. Das Licht einer Weißlicht-LED besitzt eine große Etendue, da es isotrop von einer vergleichsweise großen Fläche emittiert wird. Um dieses Licht zu kollimieren, werden in der Regel große parabolische Reflektoren oder komplizierte Linsen wie TIR-Linsen (TIR = total internal reflection) mit komplizierter Form und hohem Platzbedarf verwendet. Wird auf ein solches optisches System verzichtet und zum Beispiel nur eine einfache Linse verwendet, kann die Strahldivergenz sehr groß sein, sodass aufgrund der flächigen Ausleuchtung unterschiedliche Bereiche der Probe mit verschiedenen spektralen Eigenschaften bestrahlt werden. Dies kann mithilfe des hier vorgestellten Ansatzes verhindert werden.

Soll zum Beispiel eine Tablette untersucht werden, die auf einer Unterlage liegt, wird die Lichtquelle typischerweise so nah an die Probe herangeführt, dass nur diese und nicht die Unterlage beleuchtet wird. Dabei kann das zurückgestreute Licht aufgrund der Oberflächenkrümmung ein ortsabhängiges Spektrum besitzen. Der Beobachtungspunkt bei flächiger Beleuchtung kann beispielsweise durch Einschränkung des Sichtfelds des Detektors verkleinert werden. Hierbei kann es jedoch zu einem signifikanten Verlust an detektiertem Licht, das von der Probe zurückgestreut wird, kommen. Die Intensität des zurückgestreuten Lichts ist ohnehin relativ gering, da es sich um Photonen handelt, die mit hinreichender Tiefe in die Probe eindringen und wieder zurückgestreut werden, um ausreichend spektrale Information tragen zu können. Mithilfe des hier vorgestellten Ansatzes kann eine derartige flächige Beleuchtung der Probe und die damit verbundenen Nachteile wie beispielsweise die hohe Etendue des zurückgestreuten Lichts vermieden werden. Ferner kann dadurch auf das Positionieren des Sensors nah an der Probe verzichtet werden. Dadurch kann die Bedienbarkeit des Sensors verbessert werden, insbesondere wenn der Sensor beispielsweise auf der Rückseite eines Smartphones angebracht ist, da dieses die Probe sonst verdecken würde. Eine Beleuchtungseinheit gemäß dem hier vorgestellten Ansatz eignet sich beispielsweise auch zur Verwendung mit einem Fabry-Perot-Interferometer, auf dessen Spiegeloberflächen möglichst kollimiertes Licht fallen sollte, um die Auflösung nicht zu beeinträchtigen.

Somit ermöglicht es der hier vorgestellte Ansatz, eine Lichtquelle mitsamt Optik in Verbindung mit einem miniaturisierten Spektrometer in einem mobilen Endgerät wie beispielsweise einem Smartphone einzusetzen. Eine derartige Lichtquelle bietet den Vorteil, dass sie nur wenig Bauraum in Anspruch nimmt. Gleichzeitig kann dadurch Licht hoher Intensität mit möglichst geringen Verlusten auf einem möglichst kleinen Punkt fokussiert werden, was mit herkömmlichen Beleuchtungsverfahren nur schwer realisiert werden kann.

Gemäß der Erfindung weist die Beleuchtungseinheit ein Mikrolinsenelement zum Fokussieren des Anregungsstrahls auf das Fluoreszenzelement auf, wobei das Mikrolinsenelement eine Höhe und eine Breite von kleiner 5 mm aufweist und der Anregungspunkt einen Durchmesser von kleiner 10 µm aufweist. Gemäß einer Ausführungsform kann die Beleuchtungseinheit zumindest ein Mikrolinsenelement zum Kollimieren oder Fokussieren des Anregungsstrahls oder, zusätzlich oder alternativ, des Beleuchtungsstrahls aufweisen. Unter einem Mikrolinsenelement kann beispielsweise ein Linsenelement oder ein holografisches optisches Element mit einer Höhe oder einer Breite von kleiner 5 mm verstanden werden. Insbesondere kann das Mikrolinsenelement eine Höhe oder eine Breite von kleiner 2 mm aufweisen. Je nach Ausführungsform kann die Beleuchtungseinheit auch eine Mehrzahl solcher Mikrolinsenelemente aufweisen. Dadurch kann die Beleuchtungseinheit möglichst kompakt realisiert werden. Ferner wird dadurch eine Kollimierung oder Fokussierung des Anregungsstrahls oder des Beleuchtungsstrahls ermöglicht.

Dabei kann das Mikrolinsenelement als Kugellinse ausgeführt sein. Dadurch können die Herstellungskosten der Beleuchtungseinheit reduziert werden.

Gemäß der Erfindung weist das Mikrolinsenelement eine Höhe und Breite von kleiner 5 mm auf. Dadurch kann der Bauraumbedarf der Beleuchtungseinheit reduziert werden.

Es ist von Vorteil, wenn die Laser-Anregungslichtquelle ausgebildet ist, um Ultraviolettstrahlung oder, zusätzlich oder alternativ, blaues Licht als den Anregungsstrahl auszusenden. Zusätzlich oder alternativ kann das Fluoreszenzelement ausgebildet sein, um polychromatisches Licht als den Beleuchtungsstrahl zu erzeugen. Dadurch kann die Probe mit geringem Aufwand mit einem wohldefinierten, breiten Spektrum beleuchtet werden.

Ferner ist es vorteilhaft, wenn die Beleuchtungseinheit zumindest ein zwischen der Laser-Anregungslichtquelle und dem Fluoreszenzelement angeordnetes Filterelement aufweist, das ausgebildet ist, um den Anregungsstrahl in Richtung des Fluoreszenzelements durchzulassen und elektromagnetische Strahlung mit einer von einer Wellenlänge des Anregungsstrahls abweichenden Wellenlänge in Richtung des Fluoreszenzelements herauszufiltern. Bei dem Filterelement kann es sich beispielsweise um einen Kurzpassfilter handeln, der ausgebildet ist, um kurzwellige elektromagnetische Strahlung durchzulassen und elektromagnetische Strahlung mit größeren Wellenlängen zu blockieren. Beispielsweise kann das Filterelement als halbdurchlässiges Spiegelelement realisiert sein. Dadurch kann die Effizienz der Beleuchtungseinheit erhöht werden.

Gemäß einer weiteren Ausführungsform kann die Beleuchtungseinheit zumindest ein zwischen dem Filterelement und dem Fluoreszenzelement angeordnetes Zusatzmikrolinsenelement aufweisen, das ausgebildet ist, um den von dem Filterelement durchgelassenen Anregungsstrahl auf das Fluoreszenzelement zu lenken. Zusätzlich oder alternativ kann das Zusatzmikrolinsenelement ausgebildet sein, um den Beleuchtungsstrahl auf das Filterelement zu lenken. Dabei kann das Filterelement ausgebildet sein, um den Beleuchtungsstrahl in einen Auskoppelstrahlengang zum Auskoppeln des Beleuchtungsstrahls aus der Beleuchtungseinheit zu lenken. Unter einem Auskoppelstrahlengang kann ein aus der Beleuchtungseinheit herausführender Strahlengang verstanden werden. Ähnlich wie das Mikrolinsenelement kann es sich bei dem Zusatzmikrolinsenelement um ein Linsenelement mit einer Höhe oder einer Breite von kleiner 5 mm handeln. Durch diese Ausführungsform kann die Effizienz der Beleuchtungseinheit weiter erhöht werden.

Das Zusatzmikrolinsenelement kann gemäß einer weiteren Ausführungsform ausgebildet sein, um den Anregungsstrahl auf das Fluoreszenzelement zu fokussieren oder, zusätzlich oder alternativ, den Beleuchtungsstrahl beim Lenken auf das Filterelement zu kollimieren. Dadurch kann der Beleuchtungsstrahl zusätzlich kollimiert oder fokussiert werden.

Des Weiteren kann das Fluoreszenzelement eine Lichteintrittsfläche und eine der Lichteintrittsfläche gegenüberliegende Lichtaustrittsfläche aufweisen. Das Fluoreszenzelement kann derart an der Laser-Anregungslichtquelle angeordnet sein, dass die Lichteintrittsfläche der Laser-Anregungslichtquelle zugewandt ist und sich im Strahlengang des Anregungsstrahls befindet. Unter einer Lichteintrittsfläche kann eine Oberfläche des Fluoreszenzelements verstanden werden, über die der Anregungsstrahl in das Fluoreszenzelement eintritt. Entsprechend kann unter einer Lichtaustrittsfläche eine Oberfläche des Fluoreszenzelements verstanden werden, über die der Anregungsstrahl aus dem Fluoreszenzelement austritt. Beispielsweise kann die Lichteintrittsfläche flächig auf der Laser-Anregungslichtquelle aufliegen oder einen geringen Abstand zur Laser-Anregungslichtquelle aufweisen. Durch diese Ausführungsform kann auf die Verwendung zusätzlicher optischer Bauelemente zwischen Laser-Anregungslichtquelle und Fluoreszenzelement verzichtet werden. Dadurch kann der gesamte Bauraum der Beleuchtungseinheit deutlich reduziert werden und es können die Herstellungskosten der Beleuchtungseinheit reduziert werden.

Von Vorteil ist zudem, wenn die Beleuchtungseinheit zumindest ein Faltungselement zum Falten des Anregungsstrahls aufweist. Unter einem Faltungselement kann beispielsweise ein Spiegel, eine Linse oder ein holografisches optisches Element verstanden werden. Dadurch kann die Beleuchtungseinheit möglichst kompakt realisiert werden. Zusätzlich oder alternativ kann die Beleuchtungseinheit zumindest ein spektral durchstimmbares Zusatzfilterelement zum Filtern des Beleuchtungsstrahls aufweisen. Bei dem Zusatzfilterelement kann es sich beispielsweise um einen Fabry-Perot-Resonator oder einen linear variablen Filter handeln. Dadurch kann die spektrale Zusammensetzung des Beleuchtungsstrahls je nach Anwendungsfall variiert werden.

Der hier vorgestellte Ansatz schafft ferner ein Mikrospektrometer gemäß Anspruch 11 mit folgenden Merkmalen: zumindest einer Beleuchtungseinheit gemäß den Merkmalen aus einem der Ansprüche 1 bis 10; und zumindest einer Detektoreinheit zum Detektieren eines reflektierten Beleuchtungsstrahls der Beleuchtungseinheit.

Unter einer Detektoreinheit kann ein lichtempfindliches Sensorelement zum Ermitteln einer spektralen Zusammensetzung des reflektierten Beleuchtungsstrahls verstanden werden. Ein solches Mikrospektrometer bietet den Vorteil einer besonders kompakten Bauform.

Zudem schafft der hier vorgestellte Ansatz ein mobiles Endgerät gemäß Anspruch 12 mit folgenden Merkmalen: zumindest ein Mikrospektrometer gemäß den Merkmalen aus Anspruch 11.

Das mobile Endgerät kann eine Übertragungsschnittstelle zur mobilen Kommunikation, beispielsweise eine Mobilfunkschnittstelle aufweisen. Unter einem mobilen Endgerät kann beispielsweise ein Mobiltelefon, insbesondere etwa ein Smartphone, ein Tablet-PC, ein Laptop oder ein sonstiges tragbares elektronisches Gerät verstanden werden. Schließlich schafft der hier vorgestellte Ansatz ein Verfahren zum Beleuchten einer Probe mittels einer Beleuchtungseinheit gemäß einem der Ansprüche 1 bis 10, wobei das Verfahren folgende Schritte umfasst:
Aussenden des Anregungsstrahls; und
Erzeugen des Beleuchtungsstrahls zum Beleuchten der Probe durch Anregen des Fluoreszenzelements mittels des Anregungsstrahls.

Dieses Verfahren kann beispielsweise in Software oder Hardware oder in einer Mischform aus Software und Hardware, beispielsweise in einem Steuergerät, implementiert sein.

Ausführungsbeispiele der Erfindung sind in den Zeichnungen dargestellt und in der nachfolgenden Beschreibung näher erläutert. Es zeigt:
Fig. 1 eine schematische Darstellung eines prinzipiellen Aufbaus eines Weißlicht-LED-Packages;
Fig. 2 eine schematische Darstellung eines prinzipiellen Aufbaus eines Weißlicht-LED-Packages;
Fig. 3 eine schematische Darstellung der Etendue eines Strahlenbündels;
Fig. 4 eine schematische Darstellung einer Beleuchtungseinheit gemäß einem Ausführungsbeispiel;
Fig. 5 eine schematische Darstellung einer Beleuchtungseinheit gemäß einem Ausführungsbeispiel;
Fig. 6 eine schematische Darstellung einer Beleuchtungseinheit gemäß einem Ausführungsbeispiel;
Fig. 7 eine schematische Darstellung einer Beleuchtungseinheit gemäß einem Ausführungsbeispiel;
Fig. 8 eine schematische Darstellung eines Mikrospektrometers gemäß einem Ausführungsbeispiel in der Draufsicht;
Fig. 9 eine schematische Darstellung eines Mikrospektrometers aus Fig. 8 in der Seitenansicht;
Fig. 10 eine schematische Darstellung eines mobilen Endgeräts mit integriertem Spektralsensor;
Fig. 11 eine schematische Darstellung eines mobilen Endgeräts mit integriertem Mikrospektrometer gemäß einem Ausführungsbeispiel;
Fig. 12 eine schematische Darstellung einer Beleuchtungseinheit gemäß einem Ausführungsbeispiel;
Fig. 13 eine schematische Darstellung einer Beleuchtungseinheit gemäß einem Ausführungsbeispiel; und
Fig. 14 ein Ablaufdiagramm eines Verfahrens gemäß einem Ausführungsbeispiel.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

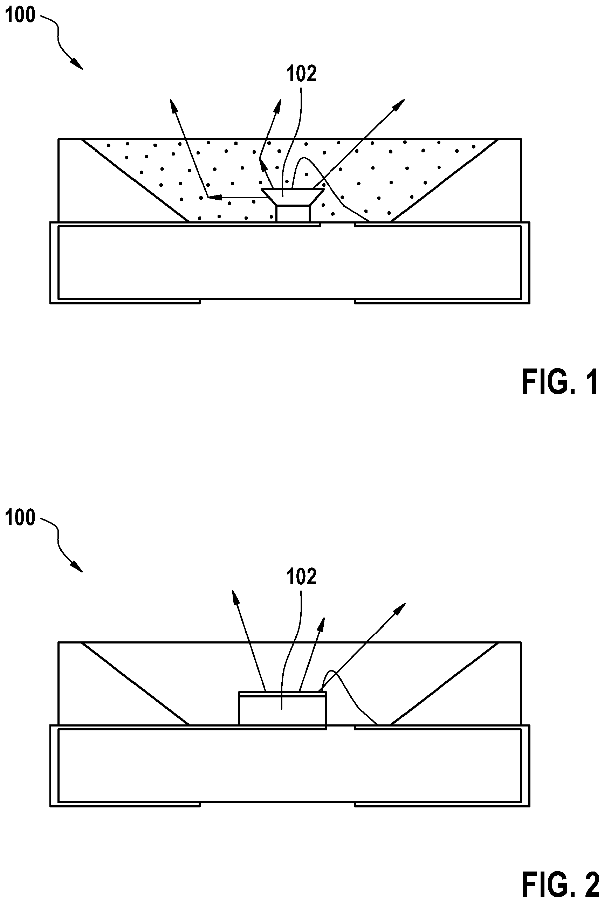

Fig. 1 zeigt eine schematische Darstellung eines prinzipiellen Aufbaus eines Weißlicht-LED-Packages 100. Gezeigt ist ein LED-Chip 102, der kurzweiliges Licht emittiert. Das emittierte Licht wird von einem Phosphor, dargestellt als punktförmige Partikel, in weißes Licht konvertiert.

Fig. 2 zeigt eine schematische Darstellung eines prinzipiellen Aufbaus eines Weißlicht-LED-Packages 100. Im Unterschied zu Fig. 1 ist der Phosphor hier als Schicht auf dem LED-Chip 102 aufgebracht.

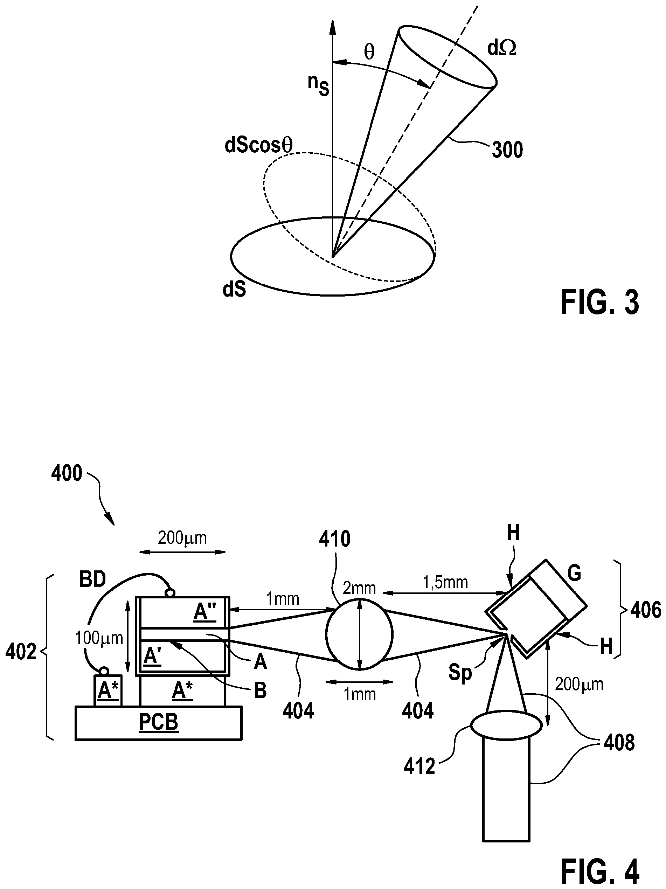

Fig. 3 zeigt eine schematische Darstellung der Etendue G eines Strahlenbündels 300. Die Etendue G des Strahlenbündels 300 ist das Produkt aus dessen Öffnungswinkel Ω, der Fläche S, durch das das Strahlenbündel 300 hindurchtritt, seiner Flächennormalen n und dem Richtungskosinus cosΘ. Die Etendue ist eine Erhaltungsgröße, was bedeutet, dass ein diffuser Strahl mit einem bestimmten Durchmesser nur kollimiert werden kann (Öffnungswinkel Ω kleiner), wenn gleichzeitig sein Durchmesser (Fläche S) größer wird.

Fig. 4 zeigt einer Beleuchtungseinheit 400 gemäß einem Ausführungsbeispiel. Die Beleuchtungseinheit 400 für ein Mikrospektrometer umfasst eine Laser-Anregungslichtquelle 402 zum Aussenden eines Anregungsstrahls 404 sowie ein in einem Strahlengang des Anregungsstrahls 404 angeordnetes Fluoreszenzelement 406, das durch Anregung mittels des Anregungsstrahls 404 einen Beleuchtungsstrahl 408 erzeugt, der sich zur Beleuchtung einer mittels des Mikrospektrometers zu analysierenden Probe eignet. Hierbei weist der Beleuchtungsstrahl 408 ein deutlich breiteres elektromagnetisches Spektrum als der Anregungsstrahl 404 auf.

Beispielhaft ist die Laser-Anregungslichtquelle 402 gemäß Fig. 4 als Chip mit einer Laserdiode zum Aussenden eines Laserstrahls als Anregungsstrahl 404 ausgeführt. Zusätzlich ist im Strahlengang des Anregungsstrahls 404 zwischen der Lichtquelle 404 und dem Fluoreszenzelement 406 ein Mikrolinsenelement 410 angeordnet, das ausgebildet ist, um den Anregungsstrahl 404 auf das Fluoreszenzelement 406 zu fokussieren. Das Mikrolinsenelement 410 weist beispielhaft eine Höhe von 2 mm und eine Breite von 1 mm auf. Je nach Ausführungsbeispiel kann das Mikrolinsenelement 410 auch davon abweichende Abmessungen beispielsweise von kleiner 5 mm oder kleiner 4 mm aufweisen. Ein weiteres optionales Mikrolinsenelement 412 mit ähnlichen Abmessungen wie das Mikrolinsenelement 410 ist ausgebildet, um den von dem Fluoreszenzelement 406 ausgesandten Beleuchtungsstrahl 408 zu kollimieren, bevor er aus der Beleuchtungseinheit 400 austritt.

Die in Fig. 4 angegebenen Größenangaben sind Schätzwerte auf Basis einer beispielhaften Mikrolinse, die mit Zemax simuliert wurde. Je nach Ausführungsbeispiel können die Komponenten der Beleuchtungseinheit 400 in der Realität auch davon abweichende Abmessungen aufweisen.

Gemäß einem Ausführungsbeispiel ist die Laser-Anregungslichtquelle 402 ausgebildet, um kurzweilige elektromagnetische Strahlung im Wellenlängenbereich zwischen ultraviolettem und blauem Licht als den Anregungsstrahl 404 auszusenden. Hierbei ist das Fluoreszenzelement 406 ausgebildet, um unter Verwendung des Anregungsstrahls 404 weißes Licht als den Beleuchtungsstrahl 408 zu erzeugen. Die Beleuchtungseinheit 400 fungiert somit als Weißlichtquelle.

In Fig. 4 ist der prinzipielle Aufbau der Beleuchtungseinheit 400 auf Basis einer Laserdiode als Laser-Anregungslichtquelle 402 und eines lichtkonvertierenden Phosphorelements als Fluoreszenzelement 406 gezeigt. Beispielsweise weist das Fluoreszenzelement 406 ein Volumen von etwa 1 mm³ auf, beispielsweise ein Volumen von weniger als 4mm³ oder weniger als 2mm³. Hierbei dient ein Laserdioden-Chip A mit einer aktiven Region B als Quelle für das Anregungslicht. Der Chip A wird beispielsweise über zwei Kontakte A' eines n-Substrats und A" einer p-dotierten Schicht auf einer Leiterplatte PCB mit Leiterbahnen A* befestigt. Ein Bonddraht BD verbindet den Kontakt A" der p-Schicht mit der Leiterplatte PCB.

Gemäß einem Ausführungsbeispiel weist der Laserdioden-Chip A eine Breite von weniger als 500 µm, beispielsweise von 200 µm auf. Eine Höhe des Stapels aus dem Laserdioden-Chip A und den Leiterbahnen bzw. Kontaktierungen A', A" beträgt gemäß einem Ausführungsbeispiel weniger als 500 µm, beispielsweise 100 µm.

Als Lichtquelle dient beispielsweise ein Kantenemitter mit elliptischem Strahlprofil oder ein Oberflächenemitter mit rundem Strahlprofil, auch vertical-cavity surfaceemitting laser oder kurz VCSEL genannt. Eine Lichtemissionszone der Laser-Anregungslichtquelle 402 ist mit dem Buchstaben B gekennzeichnet. Der emittierte Anregungsstrahl 404 hat beispielsweise ein schmales Spektrum im kurzwelligen Bereich von Blau bis Ultraviolett. Das Mikrolinsenelement 410, je nach Ausführungsbeispiel etwa eine Kugellinse, eine asphärische Linse oder ein holografisches optisches Element, fokussiert den Anregungsstrahl 404 auf einen kleinen Bereich des Fluoreszenzelements 406. Dieses ist optional mit einer Wärmesenke G verbunden, um überschüssige Wärme ableiten zu können. Das Mikrolinsenelement 410 sollte eine möglichst hohe numerische Apertur aufweisen, um einen möglichst kleinen Beleuchtungspunkt Sp auf dem Fluoreszenzelement 406 zu erzeugen. Der Beleuchtungspunkt Sp, auch Fokus oder Anregungspunkt genannt, weist erfindungsgemäß einen Durchmesser von kleiner 10 µm auf.

Erfindungsgemäß weist das Mikrolinsenelement 410 eine Höhe und eine Breite von weniger als 5 mm, beispielsweise eine Höhe von 2 mm und eine Breite von 1 mm auf. Ein Abstand zwischen dem Mikrolinsenelement 410 und dem Laserdioden-Chip A beträgt gemäß einem Ausführungsbeispiel weniger als 5 mm, beispielsweise 1 mm und ein Abstand zwischen dem Mikrolinsenelement 410 und dem Fluoreszenzelement 406 weniger als 5 mm, beispielsweise 1,5 mm

Die untere Grenze für eine sinnvolle Größe des Fokus Sp wird nicht nur durch die fokussierenden Eigenschaften des Mikrolinsenelements 410, sondern auch durch die erzeugte Energiedichte auf dem Fluoreszenzelement 406 bestimmt, da oberhalb der Sättigungsintensität des Fluoreszenzelements 406 trotz erhöhter Anregungsintensität keine Steigerung der emittierten Lichtintensität mehr eintritt. Zusätzlich ist zu beachten, dass der Anregungsstrahl 404 in das Fluoreszenzelement 406 eindringt und so das Anregungsvolumen vergrößert. Auch kann durch Fluoreszenz emittiertes Licht in dem Fluoreszenzelement 406 diffundieren und an einer anderen Stelle als dem Anregungsfokus Sp austreten. Beides würde die Etendue der Laser-Anregungslichtquelle 402 vergrößern. Um dem entgegenzuwirken, ist das Fluoreszenzelement 406 entweder sehr klein gehalten oder zusätzlich oder alternativ mit einer reflektierenden oder absorbierenden Schicht H umschlossen, die nur am Anregungspunkt Sp eine Offnung aufweist, auch Pinhole genannt. Erfindungsgemäß ist letztere Alternative. Das emittierte, breitbandige Licht in Form des Beleuchtungsstrahls 408 wird dann durch das weitere Mikrolinsenelement 412 zu einem kollimierten oder wieder fokussierten Strahl geformt.

Gemäß einem Ausführungsbeispiel beträgt ein Abstand zwischen dem Mikrolinsenelement 412 und dem Fluoreszenzelement 406 weniger als 500 µm, beispielsweise 200 µm.

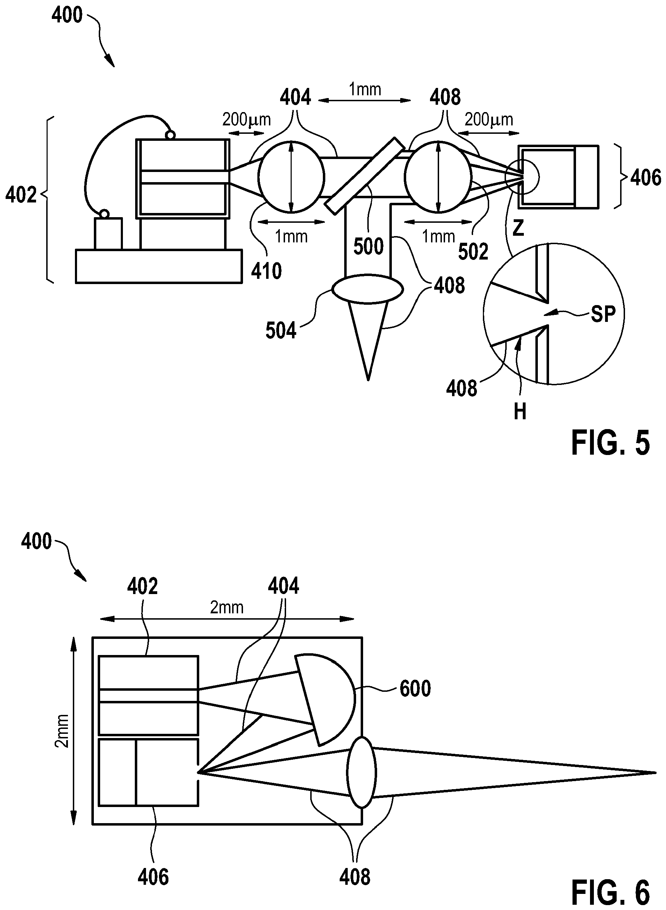

Das Fluoreszenzelement 406 emittiert dabei in den gesamten Raum, was zur Folge hat, dass unter Umständen ein beträchtlicher Teil des umgewandelten Lichts nicht auf das weitere Mikrolinsenelement 412 trifft und so verloren geht. Zwar wäre es möglich, die Ränder der Öffnung am Anregungspunkt Sp entsprechend dick zu formen, sodass der Beleuchtungsstrahl 408 die Öffnung nicht unter zu großen Winkeln verlässt, allerdings könnte dies auch zu Lichtstreuung in unerwünschte Richtungen führen, was effektiv die Etendue der Beleuchtungseinheit 400 wieder vergrößern würde. Eine Möglichkeit, dieses Problem zu umgehen, ist in Fig. 5 gezeigt.

Die Beleuchtungseinheit 400 ist beispielsweise als Komponente eines miniaturisierten Spektrometers zur Verwendung als integrierter Sensor in einem tragbaren Gerät, etwa einem Smartphone, einsetzbar.

Eine fundamentale Grenze bei der Kollimation einer ausgedehnten, diffusen Lichtquelle stellt die Etendue G dar. Diese ist eine Erhaltungsgröße und besagt unter anderem, dass der Öffnungswinkel, in den eine ausgedehnte Lichtquelle abstrahlt, nur verkleinert werden kann (was einer Kollimation entspricht), wenn sich die Querschnittsfläche des Strahlprofils gleichzeitig vergrößert. Dies hat zur Folge, dass Optiken zum Kollimieren einer LED relativ zur LED sehr groß sein sollten, sodass die Quelle als punktförmig angesehen werden kann. Bei kleinen optischen Elementen leidet die Effizienz der Kollimation und es bleiben stets zueinander nicht parallele Strahlen übrig. Dies ist zum Beispiel für den Blitz einer Smartphone-Kamera nicht hinderlich, bei der ebensolche LEDs mit Mikrooptiken zum Tragen kommen, da ohnehin eine große Fläche ausgeleuchtet werden soll, aber nachteilig für die Verwendung als Lichtquelle in Verbindung mit einem miniaturisierten Spektrometer.

Um dies zu vermeiden, sieht der hier vorgestellte Ansatz gemäß einem Ausführungsbeispiel die Verwendung einer kurzwelligen Laserdiode als Laser-Anregungslichtquelle 402 vor, die auf einen Phosphor oder ein anderes Fluoreszenzelement mit breitbandiger Fluoreszenzemission fokussiert wird. Ein Laser kann auf einen sehr kleinen Bereich mit hoher Energiedichte fokussiert werden, der dann als Emitter mit breitem Spektrum dient. So kann etwa mithilfe einer einzelnen asphärischen Linse eine Fokusgröße von kleiner 10 µm erreicht werden. Demgegenüber hat beispielsweise der Fokuspunkt eines CD-Laufwerks einen Durchmesser von etwa 1,5 µm und der Fokuspunkt eines Blu-Ray-Laufwerks einen Durchmesser von etwa 300 nm.

Fig. 5 zeigt eine schematische Darstellung einer Beleuchtungseinheit 400 gemäß einem Ausführungsbeispiel. Im Unterschied zu Fig. 4 ist hinter das Mikrolinsenelement 410 ein Filterelement 500, hier ein Kurzpassfilter in Form eines dichroitischen Spiegels, gesetzt. Das Filterelement 500 ist ausgebildet, um kurzwelliges Anregungslicht in Form des Anregungsstrahls 404 in Richtung des Fluoreszenzelements 406 passieren zu lassen. Zwischen dem Filterelement 500 und dem Fluoreszenzelement 406 ist ein optionales Zusatzmikrolinsenelement 502 angeordnet, das den durchgelassenen Anregungsstrahl 404 auf die Öffnung im Fokus Sp des Fluoreszenzelements 406 fokussiert. In umgekehrter Richtung wird das aus der Öffnung im Fokus Sp austretende Fluoreszenzlicht in Form des Beleuchtungsstrahls 408 von dem Zusatzmikrolinsenelement 502 aufgesammelt und wiederum kollimiert. Das Zusatzmikrolinsenelement 502 sollte dabei eine möglichst hohe numerische Apertur aufweisen, um möglichst viel Fluoreszenzlicht einzusammeln. Ein Ausschnitt Z zeigt eine vergrößerte Ansicht des Emissionspunktes Sp, an dem die Kanten der Öffnung in der Beschichtung H beispielhaft so geformt sind, etwa in Form eines Paraboloids, dass der Emissionskegel des Beleuchtungsstrahls 408 nicht zu weit auffächert und das Zusatzmikrolinsenelement 502 effizient ausleuchtet. Das Mikrolinsenelement 410 und das Zusatzmikrolinsenelement 502 sind beispielsweise baugleich.

Der Beleuchtungsstrahl 408 wird aufgrund seiner größeren Wellenlänge durch das Filterelement 500 umgelenkt, der in diesem Bereich größerer Wellenlängen reflektiert, und verlässt die Beleuchtungseinheit 400 durch eine fokussierende Optik 504, hier in Form eines zusätzlichen Mikrolinsenelements. Durch das in Fig. 5 gezeigte Prinzip eines Strahlengangs kann die Sammeleffizienz des emittierten Fluoreszenzlichts erhöht werden. Dabei wird das Anregungslicht effizient unterdrückt, sodass nur Fluoreszenzlicht aus der Beleuchtungseinheit 400 austritt.

Gemäß einem Ausführungsbeispiel weisen die Mikrolinsenelemente 410, 502 jeweils einen Durchmesser von weniger als 5 mm, beispielsweise von 1 mm auf. Ein Abstand zwischen den Mikrolinsenelemente 410, 502 beträgt gemäß einem Ausführungsbeispiel weniger als 5 mm, beispielsweise 1 mm.

Gemäß einem Ausführungsbeispiel beträgt ein Abstand zwischen dem Mikrolinsenelement 410 und dem Laserdioden-Chip A weniger als 500 µm, beispielsweise 200 µm und ein Abstand zwischen dem Zusatzmikrolinsenelement 502 und dem Fluoreszenzelement 406 weniger als 500 µm, beispielsweise 200 µm.

Fig. 6 zeigt eine schematische Darstellung einer Beleuchtungseinheit 400 gemäß einem Ausführungsbeispiel. Im Unterschied zu der vorangehend anhand der Figuren 4 und 5 beschriebenen Beleuchtungseinheit ist die Laser-Anregungslichtquelle 402 gemäß diesem Ausführungsbeispiel auf dem Fluoreszenzelement 406 angeordnet. Ein optionales Faltungselement 600, hier ein Spiegel, ist ausgebildet, um den aus der Laser-Anregungslichtquelle 402 austretenden Anregungsstrahl 404 derart zu falten, dass er auf die Öffnung im Fluoreszenzelement 406 trifft. So kann der optische Strahlengang gefaltet und die Größe der Beleuchtungseinheit 400 komprimiert werden. Das Faltungselement 600 ersetzt beispielsweise das in Fig. 4 gezeigte Mikrolinsenelement 410.

Gemäß einem Ausführungsbeispiel weist die Beleuchtungseinheit 400 eine Höhe und eine Länge von jeweils weniger als 5 mm, beispielsweise eine Höhe von 2 mm und eine Länge von 2 mm auf.

Gemäß dem gezeigten Ausführungsbeispiel sind die Laser-Anregungslichtquelle 402 und das Fluoreszenzelement 406 übereinandergestapelt innerhalb eines Gehäuses der Beleuchtungseinheit 400 angeordnet. Die Höhe der Beleuchtungseinheit 400 ist dabei etwas größer als die Summe aus den Höhen der Laser-Anregungslichtquelle 402 und des Fluoreszenzelements 406. Die Länge der Beleuchtungseinheit 400 ergibt sich gemäß einem Ausführungsbeispiel aus einer Länge der Laser-Anregungslichtquelle 402 bzw. des Fluoreszenzelements 406, einer Länge des Faltungselements 600 und einem Abstand zwischen dem Faltungselement 600 und der Laser-Anregungslichtquelle 402 bzw. des Fluoreszenzelements 406.

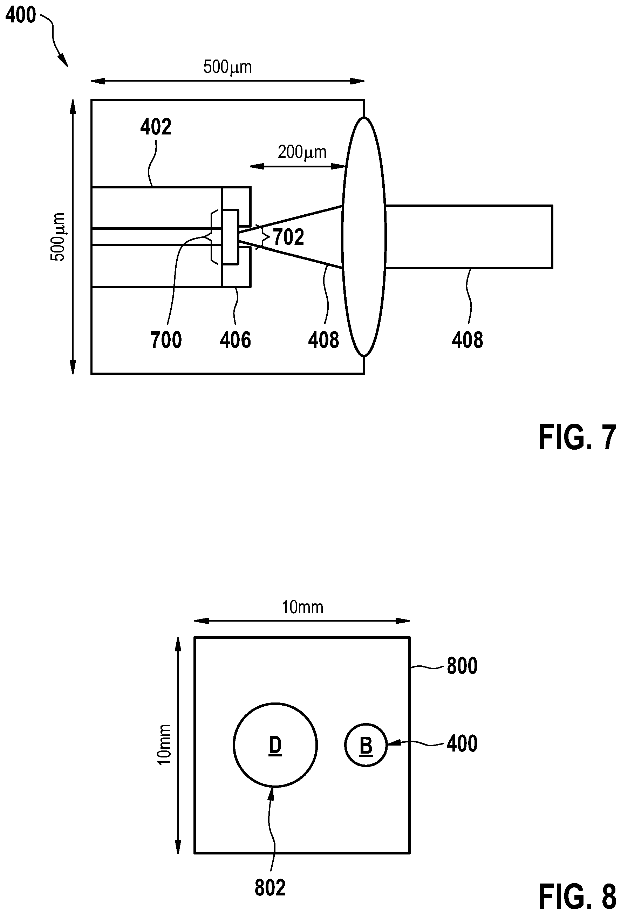

Fig. 7 zeigt eine schematische Darstellung einer Beleuchtungseinheit 400 gemäß einem Ausführungsbeispiel. Im Unterschied zu Fig. 6 ist das Fluoreszenzelement 406 hier direkt vor oder zumindest sehr nahe an einer emittierenden Fläche der Laser-Anregungslichtquelle 402 angeordnet. Das Fluoreszenzelement 406 weist eine Lichteintrittsfläche 700 und eine gegenüber der Lichteintrittsfläche befindliche Lichtaustrittsfläche 702 auf, wobei die Lichteintrittsfläche 700 der emittierenden Fläche der Laser-Anregungslichtquelle 402 zugewandt ist und sich im Strahlengang des Anregungsstrahls befindet. Beispielsweise ist der Phosphor direkt auf oder unmittelbar vor der Emissionskante der Laser-Anregungslichtquelle 402 platziert. Hierdurch wird der Anregungsstrahl direkt durch das Fluoreszenzelement 406 konvertiert. Somit kann auf eine Linse zur Fokussierung des Anregungsstrahls verzichtet werden. Da die Größe der Emissionsfläche der Laser-Anregungslichtquelle 402, etwa einer Laserdiode, beispielsweise deutlich kleiner als 1 µm² ist, kann auf diese Weise nach wie vor eine breitbandige Lichtquelle mit kleiner Etendue realisiert werden. Durch den Verzicht auf eine zusätzliche Fokussierlinse kann der Aufbau in Fig. 7 besonders klein gehalten werden.

Gemäß einem Ausführungsbeispiel weist die Beleuchtungseinheit 400 eine Länge und eine Höhe von jeweils weniger als 1000 µm, beispielsweise eine Länge von 500 µm und eine Höhe von 500 µm auf. Ein Abstand zwischen dem Fluoreszenzelement 406 und einer an einer Lichtaustrittsöffnung der Beleuchtungseinheit 400 angeordneten Linse beträgt gemäß einem Ausführungsbeispiel weniger als 500 µm, beispielsweise 200 µm.

Fig. 8 zeigt eine schematische Darstellung eines Mikrospektrometers 800 gemäß einem Ausführungsbeispiel in der Draufsicht. Gezeigt sind die Beleuchtungseinheit 400 mit einer Beleuchtungsapparatur B und eine Detektoreinheit 802 mit einer Detektionsapertur D zum Detektieren eines reflektierten Beleuchtungsstrahls der Beleuchtungseinheit 400. Bei der Beleuchtungseinheit 400 kann es sich um eine anhand der Figuren 4 bis 7 beschriebene Beleuchtungseinheit handeln.

Gemäß einem Ausführungsbeispiel weist das Mikrospektrometer 800 eine Breite und eine Höhe von jeweils weniger als 20 mm, beispielsweise eine Breite und eine Länge von jeweils 10 mm auf.

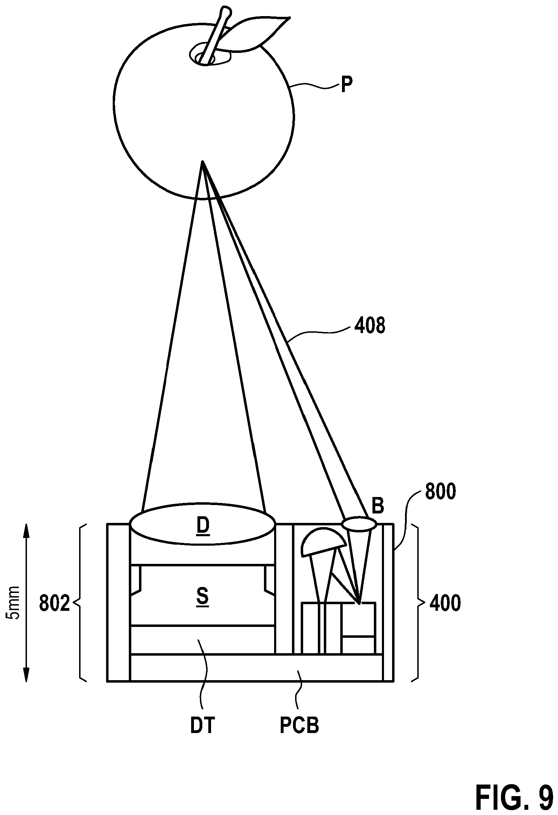

Fig. 9 zeigt eine schematische Darstellung eines Mikrospektrometers 800 aus Fig. 8 in der Seitenansicht. Zu erkennen sind die Beleuchtungseinheit 400 und die daneben angeordnete Detektoreinheit 802, bestehend aus der Detektionsoptik D, vorangehend auch Detektionsapertur genannt, einem spektralen Element S, einem Detektor DT und einer Leiterplatine PCB. Die Beleuchtungsoptik B ist so ausgelegt, dass das Sichtfeld der Detektionsapertur D ausgeleuchtet ist.

Beispielhaft ist die Verwendung des Mikrospektrometers 800 zur Untersuchung eines Apfels als Probe P gezeigt. Dabei wird der Beleuchtungsstrahl 408 auf einen bestimmten Punkt der Probe fokussiert. Die Detektionsoptik D sammelt Licht, das von diesem Punkt ausgesendet wird, wieder ein. Die Detektionsoptik D ist beispielsweise über einen optionalen Autofokus auf den Punkt fokussierbar. Dies hat den Vorteil, dass das gesamte vom Punkt reflektierte Licht hinter der Detektionsoptik D kollimiert ist und als paralleles Lichtbündel auf das spektrale Element S fällt. Kollimiertes Licht ist insbesondere erforderlich, wenn das Mikrospektrometer 800 auf einem Fabry-Perot-Interferometer oder einer anderen Dünnschichtinterferenztechnik basiert.

Gemäß einem Ausführungsbeispiel weist Detektoreinheit 802 eine Höhe von weniger als 10 mm, beispielsweise eine Höhe von 5 mm auf.

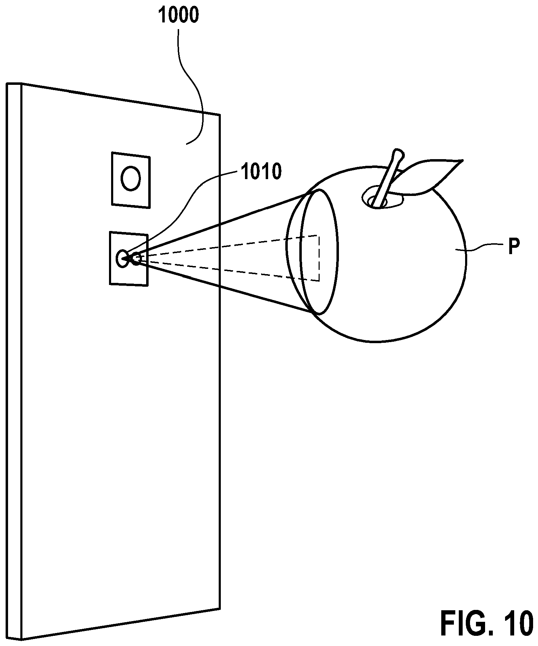

Fig. 10 zeigt eine schematische Darstellung eines mobilen Endgeräts 1000, hier eines Smartphones, mit integriertem Spektralsensor 1010. Gezeigt ist eine Beleuchtungssituation, in der die Probe P mit einer divergenten Lichtquelle des Spektralsensors 1010 beleuchtet wird. Die Lichtquelle basiert beispielsweise auf einer Weißlicht-LED. Dabei wird die Probe P relativ großflächig beleuchtet. Im ungünstigsten Fall reicht der Beleuchtungskonus sogar über die Probe P hinaus. Dabei kann durch eine Inhomogenität der Probenoberfläche und der Probenzusammensetzung die Analyse des detektierten Spektrums erschwert, verfälscht oder sogar unmöglich gemacht werden. Der Beleuchtungsfleck könnte zwar durch Annähern des Spektralsensors 1010 an die Probe P verkleinert werden, was aber auch die Nutzerfreundlichkeit deutlich verringern würde, da das Smartphone 1000 die Probe P dann verdeckt. Auch könnte sich ein großer Teil der Beleuchtungsintensität außerhalb des Gesichtsfelds der Detektionsoptik befinden, dargestellt mit einem gestrichelten Konus. Dadurch, dass der Beleuchtungsstrahl divergent ist und weit über den Detektionskonus des Detektors hinausreicht, geht dieser Teil des ausgestrahlten Lichts für die Auswertung verloren.

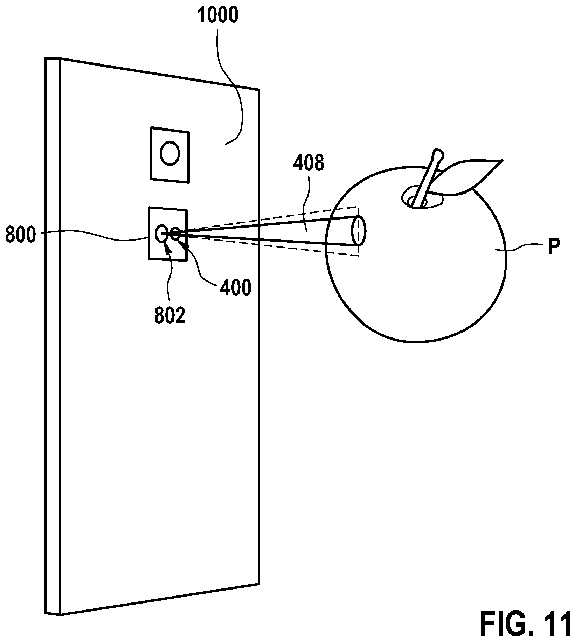

Fig. 11 zeigt das mobile Endgerät 1000 aus Fig. 10 mit integriertem Mikrospektrometer 800 gemäß einem Ausführungsbeispiel, etwa einem Mikrospektrometer, wie es vorangehend anhand der Figuren 8 und 9 beschrieben ist. Gezeigt ist eine ähnliche Beleuchtungssituation wie in Fig. 10, mit dem Unterschied, dass sich der Beleuchtungsstrahl 408 mittels der Beleuchtungseinheit 400 auf einen deutlich kleineren Bereich der Probe P als in Fig. 10 fokussieren lässt. Der Beleuchtungsstrahl 408 trifft somit einen entsprechend kleineren Probenbereich, sodass der Anregungsfleck innerhalb des Detektorsichtfeldes der Detektoreinheit 802 liegt. Das Detektorsichtfeld ist wie in Fig. 10 mit gestrichelten Linien dargestellt.

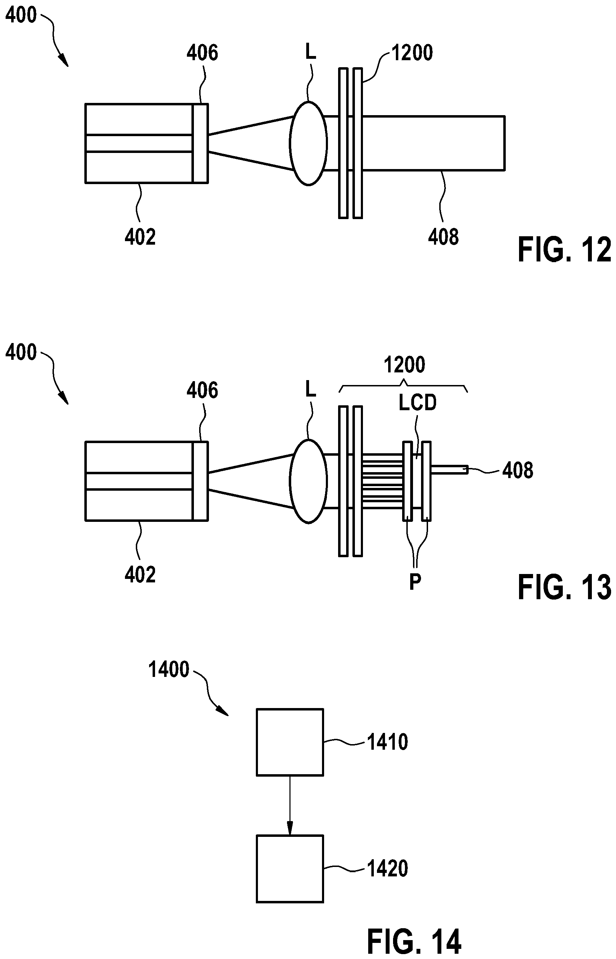

Fig. 12 zeigt eine schematische Darstellung einer Beleuchtungseinheit 400 gemäß einem Ausführungsbeispiel. Im Unterschied zu einer vorangehend anhand der Figuren 4 bis 12 beschriebenen Beleuchtungseinheit umfasst die Beleuchtungseinheit 400 gemäß diesem Ausführungsbeispiel ein optionales spektral durchstimmbares Zusatzfilterelement 1200 zum Filtern des Beleuchtungsstrahls 408, hier in Form eines Fabry-Perot-Interferometers. Beispielhaft ist das Fluoreszenzelement 406 ähnlich wie in Fig. 7 direkt an der der Laser-Anregungslichtquelle 402 angeordnet. Das in Fig. 12 gezeigte Prinzip funktioniert jedoch auch mit allen anderen vorangehend beschriebenen Ausführungsbeispielen. Aufgrund der geringen Etendue der Laser-Anregungslichtquelle 402 und der Möglichkeit, das Weißlicht sehr effizient durch eine Linse L zu kollimieren, wird je nach Ausführungsbeispiel ein Fabry-Perot-Filter, wie in Fig. 12, oder ein linear variabler Filter, wie in Fig. 13, als Zusatzfilterelement 1200 genutzt, um den Beleuchtungsstrahl 408 spektral zu filtern und so die Probe selektiv mit nur einer Wellenlänge zu beleuchten.

Fig. 13 zeigt eine Beleuchtungseinheit 400 gemäß einem Ausführungsbeispiel. Im Unterschied zu Fig. 12 ist die Beleuchtungseinheit 400 gemäß diesem Ausführungsbeispiel mit einem linear variablen Filter als Zusatzfilterelement 1200 ausgestattet.

Das anhand der Figuren 12 und 13 beschriebene Zusatzfilterelement arbeitet effektiver, wenn der Kollimationsgrad des einfallenden Lichtbündels hoch ist, was ein Vorteil der Laser-Anregungslichtquelle 402 ist. Im Ausführungsbeispiel aus Fig. 12 ist die Wellenlänge des transmittierten Beleuchtungsstrahls 408 beispielsweise durch Variieren des Abstands der beiden Resonatorspiegel zueinander einstellbar. In Fig. 13 ist die Wellenlänge des transmittierten Beleuchtungsstrahls 408 aufgrund des linearen Gradientenfilters ortsabhängig. Eine Flüssigkristallmatrix LCD mit einem davor und dahinter platzierten Polarisator P ist beispielsweise ausgebildet, um ähnlich einer Flüssigkristallanzeige einzelne Pixel zu aktivieren und so nur bestimmte spektrale Anteile des Beleuchtungsstrahls 408, der als paralleles Strahlenbündel dargestellt ist, durchzulassen.

Das durch das Fluoreszenzelement 406 emittierte Licht wird durch die Linse L kollimiert, wobei sich die geringe Etendue vorteilhaft auswirkt. Das Zusatzfilterelement 1200 kann nun genutzt werden, um bestimmte Wellenlängen des Lichts zu transmittieren. Beim Fabry-Perot-Interferometer ist die Transmissionswellenlänge vom Abstand der beiden Resonatorspiegel abhängig und kann durch Bewegen der Resonatorspiegel eingestellt werden. Bei einem linear variablen Filter ist die Transmissionswellenlänge ortsabhängig und wird selektiv durch die dahinter befindliche Flüssigkristallmatrix LCD in Verbindung mit den zwei Polarisatoren P transmittiert.

Fig. 14 zeigt ein Ablaufdiagramm eines Verfahrens 1400 gemäß einem Ausführungsbeispiel. Das Verfahren 1400 zum Beleuchten einer Probe kann beispielsweise unter Verwendung einer Beleuchtungseinheit, wie sie vorangehend anhand der Figuren 4 bis 13 beschrieben ist, durchgeführt werden. Dabei wird in einem Schritt 1410 der Anregungsstrahl von der Laser-Anregungslichtquelle ausgesandt. In einem weiteren Schritt 1420 erzeugt das Fluoreszenzelement mittels Anregung durch den Anregungsstrahl den Beleuchtungsstrahl zum Beleuchten der Probe.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Beleuchtungseinheit (400) für ein Mikrospektrometer (800) zum Analysieren einer zu analysierenden Probe (P), wobei die Beleuchtungseinheit (400) folgende Merkmale aufweist:
zumindest eine Laser-Anregungslichtquelle (402) zum Aussenden eines Anregungsstrahls (404); und
zumindest ein in einem Strahlengang des Anregungsstrahls (404) angeordnetes Fluoreszenzelement (406), das ausgebildet ist, um unter Verwendung des Anregungsstrahls (404) einen Beleuchtungsstrahl (408) zum Beleuchten der zu analysierenden Probe (P) zu erzeugen, wobei der Beleuchtungsstrahl (408) ein breiteres elektromagnetisches Spektrum als der Anregungsstrahl (404) repräsentiert,
**dadurch gekennzeichnet, dass**
die Beleuchtungseinheit (400) ein Mikrolinsenelement (410, 502) zum Fokussieren des Anregungsstrahls (404) auf einen Anregungspunkt (Sp) des Fluoreszenzelements (406) aufweist, wobei das Mikrolinsenelement (410, 502) eine Höhe und eine Breite von kleiner 5 mm aufweist und der Anregungspunkt (Sp) einen Durchmesser von kleiner als 10 µm aufweist, und
das Fluoreszenzelement (406) mit einer reflektierenden oder absorbierenden Schicht (H) umschlossen ist, die nur an dem Anregungspunkt (Sp) des Fluoreszenzelements (406) eine Öffnung aufweist.

2. Beleuchtungseinheit (400) gemäß Anspruch 1, mit zumindest einem spektral durchstimmbaren Zusatzfilterelement (1200) zum Filtern des Beleuchtungsstrahls (408).

3. Beleuchtungseinheit (400) gemäß Anspruch 2, bei der das Zusatzfilterelement als Fabry-Perot-Resonator oder als linear variabler Filter ausgebildet ist.

4. Beleuchtungseinheit (400) gemäß einem der vorangegangenen Ansprüche, bei der das Mikrolinsenelement (410, 412; 504) als Kugellinse ausgeführt ist.

5. Beleuchtungseinheit (400) gemäß einem der vorangegangenen Ansprüche, bei der die Laser-Anregungslichtquelle (402) ausgebildet ist, um den Anregungsstrahl (404) auszusenden, der ein schmales Spektrum im kurzwelligen Bereich von Blau bis Ultraviolett aufweist.

6. Beleuchtungseinheit (400) gemäß einem der vorangegangenen Ansprüche, bei der das Fluoreszenzelement (406) ausgebildet ist, um polychromatisches Licht als den Beleuchtungsstrahl (408) zu erzeugen.

7. Beleuchtungseinheit (400) gemäß einem der vorangegangenen Ansprüche, mit zumindest einem zwischen der Laser-Anregungslichtquelle (402) und dem Fluoreszenzelement (406) angeordneten Filterelement (500), das ausgebildet ist, um den Anregungsstrahl (404) in Richtung des Fluoreszenzelements (406) durchzulassen und elektromagnetische Strahlung mit einer von einer Wellenlänge des Anregungsstrahls (404) abweichenden Wellenlänge in Richtung des Fluoreszenzelements (406) herauszufiltern.

8. Beleuchtungseinheit (400) gemäß Anspruch 7, mit zumindest einem zwischen dem Filterelement (500) und dem Fluoreszenzelement (406) angeordneten Zusatzmikrolinsenelement (502), das ausgebildet ist, um den von dem Filterelement (500) durchgelassenen Anregungsstrahl (404) auf das Fluoreszenzelement (406) zu lenken und den Beleuchtungsstrahl (408) auf das Filterelement (500) zu lenken, wobei das Filterelement (500) ausgebildet ist, um den Beleuchtungsstrahl (408) in einen Auskoppelstrahlengang zum Auskoppeln des Beleuchtungsstrahls (408) aus der Beleuchtungseinheit (400) zu lenken.

9. Beleuchtungseinheit (400) gemäß Anspruch 8, bei der das Zusatzmikrolinsenelement (502) ausgebildet ist, um den Anregungsstrahl (404) auf das Fluoreszenzelement (406) zu fokussieren und den Beleuchtungsstrahl (408) beim Lenken auf das Filterelement (500) zu kollimieren.

10. Beleuchtungseinheit (400) gemäß einem der vorangegangenen Ansprüche, mit zumindest einem Faltungselement (600) zum Falten des Strahlengangs des Anregungsstrahls (404).

11. Mikrospektrometer (800) mit einer Breite von kleiner 10 mm und einer Höhe von kleiner 5 mm, wobei das Mikrospektrometer (800) folgende Merkmale aufweist:
zumindest einer Beleuchtungseinheit (400) gemäß einem der Ansprüche 1 bis 10; und
zumindest einer Detektoreinheit (802) zum Detektieren eines reflektierten Beleuchtungsstrahls (408) der Beleuchtungseinheit (400).

12. Mobiles Endgerät (1000) zur mobilen Kommunikation, wobei das Endgerät (1000) einem Mikrospektrometer (800) gemäß Anspruch 11 aufweist.

13. Verfahren (1400) zum Beleuchten einer Probe (P) mittels einer Beleuchtungseinheit (400) gemäß einem der Ansprüche 1 bis 10, wobei das Verfahren (1400) folgende Schritte umfasst:
Aussenden (1410) des Anregungsstrahls (404); und
Erzeugen (1420) des Beleuchtungsstrahls (408) zum Beleuchten der Probe (P) durch Anregen des Fluoreszenzelements (406) mittels des Anregungsstrahls (404).

## Claims

1. Illumination unit (400) for a micro-spectrometer (800) for analysing a sample (P) to be analysed, the illumination unit (400) having the following features:
at least one laser excitation light source (402) for emitting an excitation beam (404); and
at least one fluorescence element (406) arranged in a beam path of the excitation beam (404) and configured to generate, using the excitation beam (404), an illumination beam (408) for illuminating the sample (P) to be analysed, the illumination beam (408) representing a broader electromagnetic spectrum than the excitation beam (404),
**characterized in that**
the illumination unit (400) has a microlens element (410, 502) for focusing the excitation beam (404) onto an excitation point (Sp) of the fluorescence element (406), the microlens element (410, 502) having a height and a width of less than 5 mm and the excitation point (Sp) having a diameter of less than 10 µm, and
the fluorescence element (406) being enclosed by a reflective or absorbent layer (H) having an opening only at the excitation point (Sp) of the fluorescence element (406).

2. Illumination unit (400) according to Claim 1, comprising at least one spectrally tunable additional filter element (1200) for filtering the illumination beam (408).

3. Illumination unit (400) according to Claim 2, wherein the additional filter element is configured as a Fabry-Perot resonator or as a linearly variable filter.

4. Illumination unit (400) according to any of the preceding claims, wherein the microlens element (410, 412; 504) is embodied as a spherical lens.

5. Illumination unit (400) according to any of the preceding claims, wherein the laser excitation light source (402) is configured to emit the excitation beam (404) having a narrow spectrum in the shortwave range from blue to ultraviolet.

6. Illumination unit (400) according to any of the preceding claims, wherein the fluorescence element (406) is configured to generate polycrhomatic light as the illumination beam (408).

7. Illumination unit (400) according to any of the preceding claims, comprising at least one filter element (500) arranged between the laser excitation light source (402) and the fluorescence element (406) and configured to transmit the excitation beam (404) in the direction of the fluorescence element (406) and to filter out electromagnetic radiation having a wavelength deviating from a wavelength of the excitation beam (404) in the direction of the fluorescence element (406).

8. Illumination unit (400) according to Claim 7, comprising at least one additional microlens element (502) arranged between the filter element (500) and the fluorescence element (406) and configured to direct the excitation beam (404) transmitted by the filter element (500) onto the fluorescence element (406) and to direct the illumination beam (408) onto the filter element (500), the filter element (500) being configured to direct the illumination beam (408) into an output coupling beam path for coupling the illumination beam (408) out of the illumination unit (400).

9. Illumination unit (400) according to Claim 8, wherein the additional microlens element (502) is configured to focus the excitation beam (404) onto the fluorescence element (406) and to collimate the illumination beam (408) in the course of directing it onto the filter element (500).

10. Illumination unit (400) according to any of the preceding claims, comprising at least one folding element (600) for folding the beam path of the excitation beam (404).

11. Micro-spectrometer (800) having a width of less than 10 mm and a height of less than 5 mm, the micro-spectrometer (800) having the following features:
at least one illumination unit (400) according to any of Claims 1 to 10; and
at least one detector element (802) for detecting a reflected illumination beam (408) of the illumination unit (400).

12. Mobile terminal (1000) for mobile communication, the terminal (1000) having a micro-spectrometer (800) according to Claim 11.

13. Method (1400) for illuminating a sample (P) by means of an illumination unit (400) according to any of Claims 1 to 10, the method (1400) comprising the following steps:
emitting (1410) the excitation beam (404); and
generating (1420) the illumination beam (408) for illuminating the sample (P) by exciting the fluorescence element (406) by means of the excitation beam (404).

## Revendications

1. Unité d'éclairage (400) d'un microspectromètre (800) destiné à l'analyse d'un échantillon (P) à analyser, l'unité d'éclairage (400) présentant les caractéristiques suivantes :
au moins une source de lumière d'excitation laser (402) destinée à émettre un faisceau d'excitation (404) ; et
au moins un élément fluorescent (406) qui est disposé dans un trajet de faisceau du faisceau d'excitation (404) et qui est conçu pour générer, à l'aide du faisceau d'excitation (404), un faisceau d'éclairage (408) destiné à éclairer l'échantillon (P) à analyser, le faisceau d'éclairage (408) représentant un spectre électromagnétique plus large que le faisceau d'excitation (404),
**caractérisée en ce que**
l'unité d'éclairage (400) comporte un élément formant microlentille (410, 502) destiné à focaliser le faisceau d'excitation (404) sur un point d'excitation (Sp) de l'élément fluorescent (406), l'élément formant microlentille (410, 502) ayant une hauteur et une largeur inférieures à 5 mm et le point d'excitation (Sp) ayant un diamètre inférieur à 10 µm, et
l'élément fluorescent (406) étant entouré d'une couche réfléchissante ou absorbante (H) qui comporte une ouverture uniquement au point d'excitation (Sp) de l'élément fluorescent (406).

2. Unité d'éclairage (400) selon la revendication 1, comprenant au moins un élément filtrant supplémentaire (1200) qui est accordable spectralement et qui est destiné à filtrer le faisceau d'éclairage (408).

3. Unité d'éclairage (400) selon la revendication 2, dans laquelle l'élément filtrant supplémentaire est réalisé sous la forme d'un résonateur Fabry-Pérot ou sous la forme d'un filtre variable linéairement.

4. Unité d'éclairage (400) selon l'une des revendications précédentes, dans laquelle l'élément formant microlentille (410, 412 ; 504) est réalisé sous la forme d'une lentille sphérique.

5. Unité d'éclairage (400) selon l'une des revendications précédentes, dans laquelle la source de lumière d'excitation laser (402) est conçue pour émettre le faisceau d'excitation (404) qui présente un spectre étroit dans le domaine des ondes courtes allant du bleu à l'ultraviolet.

6. Unité d'éclairage (400) selon l'une des revendications précédentes, dans laquelle l'élément fluorescent (406) est conçu pour générer une lumière polychromatique comme faisceau d'éclairage (408).

7. Unité d'éclairage (400) selon l'une des revendications précédentes, comprenant au moins un élément filtrant (500) qui est disposé entre la source de lumière d'excitation laser (402) et l'élément fluorescent (406) et qui est conçu pour laisser passer le faisceau d'excitation (404) en direction de l'élément fluorescent (406) et pour exfiltrer un rayonnement électromagnétique, dont la longueur d'onde est différente de la longueur d'onde du faisceau d'excitation (404), en direction de l'élément fluorescent (406).

8. Unité d'éclairage (400) selon la revendication 7, comprenant au moins un élément formant microlentille supplémentaire (502) qui est disposé entre l'élément filtrant (500) et l'élément fluorescent (406) et qui est conçu pour diriger le faisceau d'excitation (404), passant à travers l'élément filtrant (500), sur l'élément fluorescent (406) et pour diriger le faisceau d'éclairage (408) sur l'élément filtrant (500), l'élément filtrant (500) étant conçu pour diriger le faisceau d'éclairage (408) dans un trajet de faisceau de sortie par découplage permettant au faisceau d'éclairage (408) de sortir par découplage de l'unité d'éclairage (400).

9. Unité d'illumination (400) selon la revendication 8, dans laquelle l'élément formant microlentille supplémentaire (502) est conçu pour focaliser le faisceau d'excitation (404) sur l'élément fluorescent (406) et pour effectuer une collimation du faisceau d'éclairage (408) lorsqu'il est dirigé sur l'élément filtrant (500).

10. Unité d'éclairage (400) selon l'une des revendications précédentes, comprenant au moins un élément de repliement (600) destiné à replier le trajet de faisceau du faisceau d'excitation (404).

11. Microspectromètre (800) ayant une largeur inférieure à 10 mm et une hauteur inférieure à 5 mm, le microspectromètre (800) présentant les caractéristiques suivantes :
au moins une unité d'éclairage (400) selon l'une des revendications 1 à 10 ; et
au moins une unité de détection (802) destinée à détecter un faisceau d'éclairage réfléchi (408) de l'unité d'éclairage (400).

12. Terminal mobile (1000) destiné à communication mobile, le terminal (1000) comprenant un microspectromètre (800) selon la revendication 11.

13. Procédé (1400) d'éclairage d'un échantillon (P) au moyen d'une unité d'éclairage (400) selon l'une des revendications 1 à 10, le procédé (1400) comprenant les étapes suivantes :
émettre (1410) le faisceau d'excitation (404) ; et
générer (1420) le faisceau d'éclairage (408) destiné à éclairer l'échantillon (P) par excitation de l'élément fluorescent (406) à l'aide du faisceau d'excitation (404) .
